(19) Europäisches Patentamt

European Patent Office

Office européen des brevets

(11) **EP 1 354 406 B1**

(12) **EUROPÄISCHE PATENTSCHRIFT**

(45) Veröffentlichungstag und Bekanntmachung des Hinweises auf die Patenterteilung:
**07.12.2005 Patentblatt 2005/49**

(21) Anmeldenummer: 02708155.3

(22) Anmeldetag: **21.01.2002**

(51) Int Cl.$^7$: **H03L 1/00**

(86) Internationale Anmeldenummer:
**PCT/DE2002/000171**

(87) Internationale Veröffentlichungsnummer:
**WO 2002/058242 (25.07.2002 Gazette 2002/30)**

(54) **VERFAHREN ZUM BETREIBEN EINER PLL-FREQUENZSYNTHESESCHALTUNG**

METHOD FOR OPERATING A PLL FREQUENCY SYNTHESIS CIRCUIT

PROCEDE D'UTILISATION D'UN CIRCUIT DE SYNTHESE DE FREQUENCE A BOUCLE A PHASE ASSERVIE

(84) Benannte Vertragsstaaten:
**DE FR GB IT**

(30) Priorität: **22.01.2001 DE 10102725**

(43) Veröffentlichungstag der Anmeldung:
**22.10.2003 Patentblatt 2003/43**

(73) Patentinhaber: **Infineon Technologies AG
81669 München (DE)**

(72) Erfinder: **SCHMANDT, Bernd
42329 Wuppertal (DE)**

(74) Vertreter: **Lange, Thomas
Patentanwälte
Lambsdorff & Lange
Dingolfinger Strasse 6
81673 München (DE)**

(56) Entgegenhaltungen:
**EP-A- 0 499 245        DE-A- 19 837 204
US-A- 5 598 405**

## Beschreibung

Die Erfindung betrifft ein Verfahren zum Betreiben einer PLL-Frequenzsyntheseschaltung einer TDMA/FDMA-Datenübertragungseinrichtung.

TDMA-(Time Division Multiple Access)-Verfahren und FDMA-(Frequency Division Multiple Access)-Verfahren sind Vielfachzugriffverfahren, die bei einer Vielzahl von Datenübertragungssystemen (schnurlose Telephonie, Datenaustausch zwischen Computern und Peripheriegeräten, usw.) zum Einsatz kommen. TDMA beruht auf der Unterteilung der Zeit in Zeitschlitze, welche dann für den "portionsweisen" Datenaustausch zwischen Endgeräten (z.B. Basis- und Mobilstationen) genutzt werden. FDMA repräsentiert das Analogon zu TDMA im Frequenzbereich, das heißt betrifft eine Unterteilung der Gesamtübertragungsbandbreite in einzelne Nutzerkanäle, welche mehreren Nutzern für die gleichzeitige Datenübertragung zur Verfügung stehen.

Frequenzsprungverfahren, auch als FH-(Frequency Hopping-) Verfahren bezeichnet, kennzeichnen sich dadurch, daß für jeden Sender ein ständiges Wechseln der Sendefrequenz (das heißt des Nutzerkanals) während des Sendebetriebs vorgeschrieben ist. FH erhöht die Störfestigkeit, denn es garantiert, daß eine Übertragung über einzelne, stark gestörte Kanäle stets nur kurzzeitig erfolgt und deshalb innerhalb gewisser Grenzen hingenommen werden kann.

Zur Erzeugung der Sendefrequenz wird in Datenübertragungssystemen ein PLL-(Phase Locked Loop: Nachlaufsynchronisations-) Frequenzsynthesizer eingesetzt. Für die beim FH-Verfahren benötigten Frequenzwechsel ist aufgrund von Einschwingvorgängen in der PLL eine gewisse Zeit erforderlich. Diese Zeit wird im folgenden als Einschwingzeit (Settle-Time) bezeichnet. Da die Einschwingzeit nicht zur Datenübertragung genutzt werden kann, sollte sie so kurz wie möglich gehalten werden.

Das übliche Verfahren, um eine Verkürzung der Einschwingzeit der PLL zu erreichen, besteht darin, die Übertragungsbandbreite der PLL zu vergrößern. Nachteilig ist dabei die Verschlechterung der Rauschverhaltens der PLL. Phasenregelschleifen mit kurzen Einschwingzeiten und geringem Rauschen sind aufändiger und kommen für viele Anwendungen aus Kostengründen nicht in Frage.

Ein bekanntes Verfahren zum Betreiben eines PLL-Frequenzsynethesizers bei einem Frequenzwechsel besteht darin, die PLL des Frequenzsynthesizers nach Aussendung des zuletzt übertragenen Datenbursts oder Datenpaketes zu deaktivieren. Hierfür wird der spannungsgesteuerte Oszillator der PLL abgeschaltet. Der PLL-Frequenzsynethesizer wird dann auf den nächsten gewünschten Frequenzwert eingestellt und für die Übertragung des folgenden Datenbursts erneut aktiviert. Nach dem Einschwingvorgang wird der nächste Datenburst gesendet.

In der den nächstliegenden Stand der Technik darstellenden deutschen Offenlegungsschrift DE 197 36 463 A1 ist ein Verfahren zum Betreiben einer Phasenregelschleife beschrieben, bei welchen in einem Zeitraum ohne Sendetätigkeit eine Deaktivierung der Phasenregelschleife vorgenommen wird. Diese übliche Vorgehensweise ist auch in der Schrift DE 197 36 464 A1 angesprochen.

In der deutschen Offenlegungsschrift DE 196 11 219 A1 ist eine Phasenregelschleife mit einem Schleifenfilter mit umschaltbarer Schleifenbandbreite beschrieben. Durch das Umschalten der Schleifenbandbreite wird die für einen Einschwingvorgang benötigte Zeitspanne zwischen zwei Sendevorgängen verkleinert.

Aus der Schrift DE 198 37 204 A1 ist eine programmierbare Mehrfachband-Frequenzerzeugungseinheit bekannt bei welcher verhindert wird, dass eine Ladungspumpe des Phasendetektors in der Frequenzerzeugungseinheit während der Programmierung in die Sättigung läuft, indem die Mehrfachband-Frequenzerzeugungseinheit während der Programmierung deaktiviert wird, d.h. in einem Bereitschaftsmodus gehalten wird.

Der Erfindung liegt die Aufgabe zugrunde, ein Verfahren zum Betreiben einer PLL-Frequenzsyntheseschaltung für eine TDMA/FDMA-Datenübertragungseinrichtung anzugeben, welches kurze Einschwingzeiten der PLL-Frequenzsyntheseschaltung beim Frequenzwechsel ermöglicht.

Die der Erfindung zugrundeliegende Aufgabenstellung wird durch die Merkmale des Anspruchs 1 gelöst.

Demnach besteht die der Erfindung zugrundeliegende Idee darin, die PLL-Frequenzsyntheseschaltung bei einem Frequenzwechsel nicht zu deaktivieren, sondern in dem aktiven Zustand zu halten und von diesem aktiven Zustand aus den Einschwingvorgang in die nächste Ausgabefrequenz vorzunehmen. Dabei ist vorgesehen, die PLL-Frequenzsyntheseschaltung nach Ablauf der ersten Periode mit Datenübertragungstätigkeit zunächst auf eine geeignet im nutzbaren Frequenzband gelegene Einschwing-Basisfrequenz umzuprogrammieren, und dann, ausgehend von dieser Einschwing-Basisfrequenz, die unterschiedlich zu der zweiten Ausgabefrequenz (Fout2) ist, auf die zweite Ausgabefrequenz zu wechseln.

Zwar treten auch hier Einschwingvorgänge auf; diese sind jedoch aufgrund der vergleichsweise schmalen Bandbreite des nutzbaren Frequenzbandes kürzer als beim herkömmlichen Verfahren und - wie im folgenden noch erläutert - weniger durch Herstellungstoleranzen beeinflußt.

Vorteilhaft ist das erfindungsgemäße Verfahren besonders dann, wenn nach Ablauf der ersten Periode mit Datenübertragungstätigkeit die nächste Ausgabefrequenz noch nicht bekannt ist.

Dadurch, daß für die Einschwing-Basisfrequenz die Mittenfrequenz des für den FDMA-Betrieb verwendeten Frequenzbandes gewählt wird, wird erreicht, daß der größte zu erwartende Frequenzsprung minimal wird. Da die für den Frequenzwechsel benötigte Einschwingzeit mit dem Abstand der Einschwing-Basisfrequenz zu der zweiten Ausgabefrequenz zunimmt, kann auf diese Weise eine obere Schranke mit einer minimalen Größe für die Einschwingzeit bezüglich sämtlicher möglicher Frequenzwechsel im FDMA-Frequenzband angegeben werden.

Ein besonderer Vorteil wird durch das erfindungsgemäße Verfahren erreicht, wenn der Datenübertragung eine TDMA-Struktur zugrundeliegt, bei welcher der Beginn eines bestimmten Zeitschlitzes mit dem Beginn der ersten Datenübertragungsperiode zusammenfällt und der Beginn des nächsten Zeitschlitzes mit dem Beginn der zweiten Datenübertragungsperiode zusammenfällt, und wobei die Zeitdauer zwischen dem Ende der ersten Datenübertragungsperiode und dem Anfang der zweiten Datenübertragungsperiode kürzer ist als diejenige Einschwingzeit der PLL-Frequenzsyntheseschaltung, die auftritt, wenn die PLL-Frequenzsyntheseschaltung aus dem deaktivierten Zustand auf die zweite Ausgabefrequenz geregelt würde. In diesem Fall ist bei dem erfindungsgemäßen Vorgehen in der verbleibenden Zeitdauer des betrachteten Zeitschlitzes noch ein Frequenzwechsel möglich, während beim herkömmlichen Verfahren der Frequenzwechsel zu einem späteren Zeitpunkt vollzogen werden muß. In der Praxis wird z.B. bei DECT-(Digital European Cordless Telecommunications-)Systemen häufig ein eigener Zeitschlitz der Dauer von 416µs für den Frequenzwechsel verwendet, auch deshalb, weil auf diese Weise kostengünstigere PLL mit längeren Einschwingzeiten eingesetzt werden können. Durch das erfindungsgemäße Verfahren zum Betreiben einer PLL-Frequenzsyntheseschaltung kann dieser zusätzlich benötigte Zeitschlitz ggf. wieder eingespart werden.

Weitere vorteilhafte Ausgestaltungen der Erfindung sind in den Unteransprüchen angegeben.

Die Erfindung wird nachfolgend anhand eines Beispiels unter Bezugnahme auf die Zeichnung beschrieben; in dieser zeigt:

Fig. 1 ein Blockschaltbild einer PLL-Schaltung;

Fig. 2 ein Blockschaltbild einer PLL-Frequenzsyntheseschaltung; und

Fig. 3 eine schematische Darstellung einer in einem Datenübertragungssystem verwendeten Zeitschlitz-Struktur sowie der zeitlichen Lage der Betriebszustände der PLL-Frequenzsyntheseschaltung innerhalb der Zeitschlitz-Struktur.

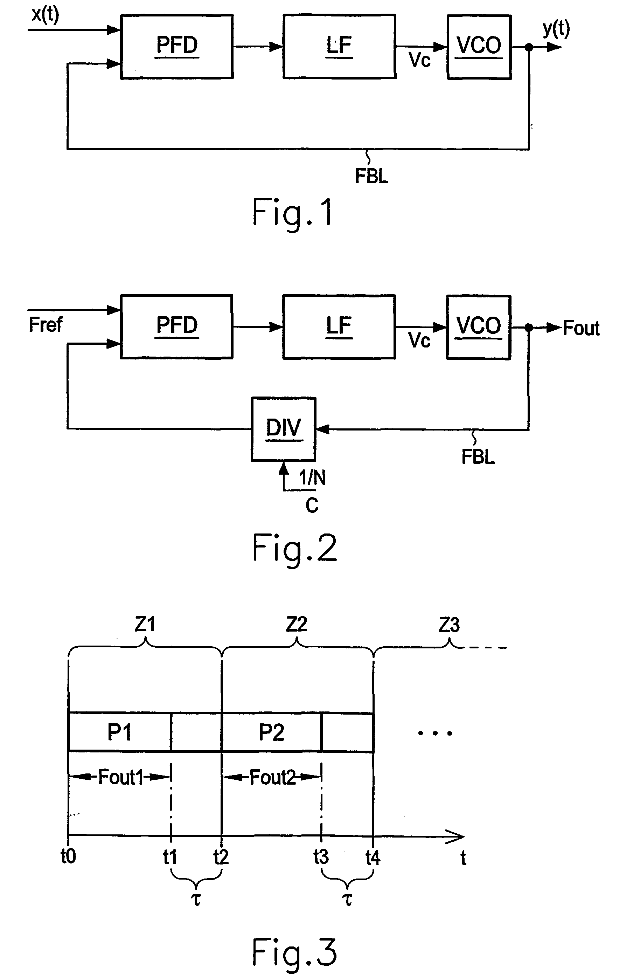

Fig. 1 zeigt den prinzipiellen Aufbau einer PLL-Schaltung. Die PLL-Schaltung umfaßt einen Phasendetektor PFD (Phase Frequency Detector), ein Schleifenfilter LF (Loop Filter) und einen spannungsgesteuerten Oszillator VCO (Voltage Controlled Oscillator). Der VCO erzeugt eine periodische Schwingung y(t), welche über eine Rückkoppelleitung FBL (Feedback Loop) einem ersten Eingang des Phasendetektors PFD zurückgeführt wird. Einem zweiten Eingang des Phasendetektors PFD wird eine Führungsgröße x(t) in Form einer Schwingung zugeführt. Die Variable t bezeichnet die Zeit.

Aufgabe der PLL-Schaltung ist es, die Ausgangsgröße y(t) in ihrem zeitlichen Verhalten der Eingangsgröße x(t) folgen zu lassen. Mit anderen Worten soll die Frequenz des spannungsgesteuerten Oszillators VCO so eingestellt werden, daß sie mit der Frequenz der Schwingung x(t) übereinstimmt. Hierzu wird die Phase des Ausgangssignals y(t) mit der Phase der Führungsgröße x(t) verglichen. Der Phasendetektor PFD gibt ein Ausgangssignal aus, welches ein Maß für die ermittelte Phasendifferenz zwischen diesen beiden Größen darstellt. Dieses Phasendifferenzsignal wird nach einer Tiefpaßfilterung in dem Schleifenfilter LF zur Steuerung des Oszillators VCO verwendet. Das Schleifenfilter LF bewirkt eine Glättung des Phasendifferenzsignals.

Aufgrund der Trägheit des Regelsystems kann die Ausgangsgröße y(t) einer sprunghaften Änderung der Führungsgröße x(t) nicht unmittelbar folgen. Die Zeit, welche benötigt wird, um die Frequenzabweichung zwischen x(t) und y(t) auf ein gewünschtes Maß zu reduzieren, wird als Einschwingzeit bezeichnet und im folgenden noch näher betrachtet.

Das anhand Fig. 1 erläuterte Regelprinzip kommt in einem PLL-Frequenzsynthesizer zur Anwendung. PLL-Frequenzsynthesizer werden in Datenübertragungseinrichtungen eingesetzt. Ihre Aufgabe besteht darin, aus einer konstanten Referenzfrequenz Fref eine gewünschte Trägerfrequenz Fout zu generieren, welche um Größenordnungen über der Referenzfrequenz liegt. Von besonderer Bedeutung ist dabei die Fähigkeit des PLL-Frequenzsynthesizers, möglichst schnell zwischen verschiedenen Ausgabefrequenzen Fout wechseln zu können. Das schnelle Wechseln zwischen verschiedenen Ausgabefrequenzen (Nutzerkanälen) ist speziell bei Datenübertragungseinrichtungen für die Mobil- bzw. Schnurlos-Telephonie von Bedeutung, da bei diesen Anwendungsfällen regelmäßig eine Vielzahl von Nutzerkanälen und das FH-Verfahren zum Einsatz kommen.

Für derartige Datenübertragungssysteme haben sich Übertragungsstandards wie DECT oder - in jüngster Zeit - Bluetooth entwickelt, die einen Frequenzsprungbetrieb FH voraussetzen. Bei FH wird jedem logischen Kanal (das heißt Teilnehmer) ein physikalischer Kanal (das heißt eine bestimmte Nutzerfrequenz) nur für eine bestimmte, kurze Zeit zugeordnet. Nach Ablauf dieser Zeit muß ein Frequenzwechsel erfolgen. Im Ergebnis wird während des gesamten Sendebetriebs (bzw. Empfangsbetriebs) ständig die Sendefrequenz (bzw. Empfangsfrequenz) gewechselt.

Fig. 2 zeigt ein Blockschaltbild eines PLL-Frequenzsynthesizers, welcher zur Durchführung des erfindungsgemäßen Verfahrens geeignet ist. Der PLL-Frequenzsynthesizer umfasst eine PLL-Schaltung gemäß Fig. 1, in deren Rückkoppelleitung FBL ein programmierbarer Frequenzteiler DIV vorhanden ist. Dem programmierbaren Frequenzteiler DIV wird ein Steuersignal C zugeführt, welches den Frequenzteiler DIV anweist, eine Frequenzteilung mit dem Teilerfaktor 1/N vorzunehmen. Unterschiedliche Ausgabefrequenzen Fout werden dann durch wiederholtes Umprogrammieren des Frequenzteilers DIV herbeigeführt.

Bei DECT liegen die Trägerfrequenzen in einem Frequenzband zwischen 1880 bis 1900 MHz. Die konstante Referenzfrequenz Fref wird von einem Schwingquarz abgeleitet und beträgt beispielsweise 5 MHz. Folglich wird bei DECT eine Frequenzteilung im Bereich zwischen 1/376 bis 1/380 vorgenommen (N kann dabei auch eine nicht ganze Zahl sein oder es kann zur Erzielung einer geeigneten Frequenzteilung ein weiterer Frequenzteiler (nicht dargestellt) mit festem Teilerverhältnis zwischen dem Schwingquarz und dem Phasendetektor PFD angeordnet sein).

Wie bereits erwähnt, ist der VCO das schwingungserzeugende Glied des PLL-Frequenzsynthesizers. Die Ausgabefrequenz Fout des VCO ergibt sich im einfachsten Fall aus einer linearen Funktion gemäß der Gleichung

$$Fout = Ffrei + Kvco \times Vc.$$

Dabei ist Ffrei die Frequenz des freilaufenden Oszillators VCO, Kvco ist die Spannungs-Frequenz-"Verstärkung" des Oszillators VCO und Vc ist die Steuerspannung, welche die Ausgabefrequenz Fout des Oszillators VCO beeinflußt.

Bei einem TDMA-Datenübertragungssystem werden die Daten "portionsweise" in sogenannten Bursts oder auch Datenpaketen übertragen. Im folgenden wird der Einfachheit halber zumeist von Datenbursts gesprochen, auch wenn Datenpakete gemeint sind.

Je nach betrachtetem Datenübertragungssystem werden in einem TDMA-Zeitschlitz entweder mehrere Datenbursts oder (maximal) ein Datenburst übertragen. Bei einer Paketübertragung ist es auch möglich, daß sich die Übertragung eines Datenpaketes über mehrere Zeitschlitze erstreckt. Die FH-Zeitpunkte sind ebenfalls je nach betrachtetem Standard unterschiedlich geregelt. Zum Beispiel können im Bluetooth-Standard in einem Zeitschlitz der Länge 625μs zwei Frequenzsprünge auftreten und zwei Datenpakete ausgesendet werden. Die FH-Frequenzwechselzeitpunkte und TDMA-Zeitschlitzstruktur sind jedoch stets zeitlich aufeinander abgestimmt, d.h. kommensurabel. In vielen Fällen sind deshalb kurze PLL-Einschwingzeiten ausgesprochen hilfreich, z.B. um eine vorgegebene Zeitschlitzstruktur bei vorgegebener Burstlänge optimal nutzen zu können, oder um eine vorgegeben minimale FH-Sprungfrequenzrate bei einer vorgegebenen Burstlänge noch erfüllen zu können.

Dies wird im folgenden anhand eines Beispiels erläutert.

Fig. 3 zeigt zwei aufeinanderfolgende Zeitschlitze Z1 und Z2. Der Zeitschlitz Z1 beginnt bei t0 und dauert bis t2, der zweite Zeitschlitz Z2 beginnt bei t2 und dauert bis t4.

Beide Zeitschlitze Z1 und Z2 werden zur Datenübertragung genutzt. In dem Zeitschlitz Z1 wird ein erster Burst P1 in einem Zeitintervall von t0 bis t1 übertragen. Im Zeitintervall von t1 bis t2 der Länge τ findet keine Datenübertragung statt. Ein zweiter Datenburst P2 wird im Zeitintervall t2 bis t3 übertragen. Das verbleibende Zeitintervall t3 bis t4 der Länge τ des zweiten Zeitschlitzes Z2 weist wiederum keine Datenübertragungstätigkeit auf.

In dem Beispiel wird davon ausgegangen, daß die Übertragung des ersten Datenbursts P1 bei einer Frequenz Fout1 erfolgt und für die Aussendung des zweiten Datenbursts eine andere Frequenz Fout2 vorgesehen ist. Dies bedeutet, daß der in Fig. 2 dargestellte PLL-Frequenzsynthesizer für die Aussendung des zweiten Datenbursts P2 von der ersten Ausgabefrequenz Fout1 zu der zweiten Ausgabefrequenz Fout2 wechseln muß.

Beim konventionellen Verfahren wird der PLL-Synthesizer hierfür nach jeder Aussendung eines Datenbursts P1, P2, das heißt zu den Zeitpunkten t1 und t3, abgeschaltet. Der Grund für die Abschaltung besteht in einer Leistungsersparnis während der Zeitdauern t1 bis t2 bzw. t3 bis t4, in denen keine Datenübertragungstätigkeit stattfindet. Nach dem Abschalten des PLL-Frequenzsynthesizers wird dann der programmierbare Frequenzteiler DIV auf den gewünschten Wert für die zweite Ausgabefrequenz Fout2 umprogrammiert und der PLL-Frequenzsynthesizer wird erneut aktiviert.

Sofern τ ausreichend lang ist, treten dabei keine Probleme auf. Schwierigkeiten ergeben sich jedoch für kurze Zeiten von τ.

Denn beim erneuten Anschalten des Oszillators VCO schwingt dieser zunächst mit der Freilauffrequenz Ffrei an. Eine exakte Einstellung der Freilauffrequenz Ffrei ist aufgrund von Fertigungstoleranzen nicht möglich. Deshalb tritt in der Praxis der Fall auf, daß die Freilauffrequenz Ffrei außerhalb des vorgesehenen FDMA-Frequenzbandes liegt. In diesem Fall verlängert sich durch die Regelverzögerung der PLL die Gesamtzeit, die für den Einschwingvorgang vom deaktivierten Zustand auf die gewünschte Ausgabefrequenz Fout2 benötigt wird.

Um einen Frequenzwechsel in kürzerer Zeit durchführen zu können, sieht die Erfindung vor, den spannungsgesteuerten Oszillator VCO nach Abarbeitung des vorhergehenden Datenbursts P1 nicht zu deaktivieren, sondern auf eine andere geeignete Frequenz im Frequenzband, insbesondere auf dessen Mittenfrequenz, einzuregeln und von dort auf die Zielfrequenz Fout2 umzuprogrammieren. Der Einschwingvorgang erfolgt dann von Fout1 über die geeignete Frequenz nach Fout2 und ist schneller als beim herkömmlichen Verfahren.

Insbesondere sofern die Zielfrequenz Fout2 zum Zeitpunkt t1 noch nicht bekannt ist, ermöglicht das erfindungsgemäße Verfahren, in kürzester Zeit in die zweite Ausgabefrequenz Fout2 überzuwechseln, sobald die neue Frequenzinformation für den PLL-Frequenzsynthesizer bereitsteht.

Es wird darauf hingewiesen, daß die Erfindung in bestimmten Fällen eine Erhöhung der Informationsübertragungsrate ermöglicht. Dies ist der Fall, wenn beim konventionellen Vorgehen (Deaktivieren des VCO nach jeder Datenburst-Übertragung) die verbleibende Zeit τ bis zum Beginn des nächsten Zeitschlitzes Z2 bei entsprechend knapper Dimensionierung der Zeitschlitzstruktur nicht mehr ausreicht, um den PLL-Frequenzsynthesizer bis zum Zeitpunkt t2 in den eingeschwungenen Zustand (Ausgabefrequenz: Fout2) zu bringen. In diesem Fall kann der Datenburst P2 nicht im Zeitschlitz Z2 ausgesendet werden, sondern die Aussendung des Datenburst P2 muß in den nächsten zeitschlitz Z3 oder in einen noch späteren Zeitschlitz verlegt werden. Durch die mittels des erfindungsgemäßen Verfahrens erzielte Verkürzung der Einschwingzeit kann in einer solchen Situation der Einschwingvorgang eventuell noch rechtzeitig zum Zeitpunkt t2 abgeschlossen werden, so daß der Datenburst P2 noch im zweiten Zeitschlitz Z2 übertragen wird. Insofern kann auch vorgesehen sein, das erfindungsgemäße Verfahren nur zeitweise als Betriebsmodus einzusetzen, nämlich dann, wenn eine hohe Datenrate benötigt wird, und andernfalls die PLL in dem herkömmlichen Betriebsmodus mit Abschaltung zwischen Aktivitätsperioden zu betreiben.

**Patentansprüche**

1. Verfahren zum Betreiben einer PLL-Frequenzsyntheseschaltung einer TDMA/FDMA-Datenübertragungseinrichtung, wobei für die Durchführung eines Frequenzwechsels

   - sich die PLL-Frequenzsyntheseschaltung (PFD, LF, VCO, DIV) während einer ersten Periode (t0-t1) mit Datenübertragungstätigkeit (P1) in einem aktiven Zustand befindet und eine erste Ausgabefrequenz (Fout1) synthetisiert,
   - während einer sich daran anschließenden Zwischenperiode (t1-t2) keine Datenübertragungstätigkeit der TDMA/FDMA-Datenübertragungseinrichtung vorgesehen ist, und
   - sich die PLL-Frequenzsyntheseschaltung (PFD, LF, VCO, DIV) während einer an die Zwischenperiode (t1-t2) anschließenden zweiten Periode (t2-t3) mit Datenübertragungstätigkeit (P2) erneut in einem aktiven Zustand befindet und eine zweite Ausgabefrequenz (Fout2) synthetisiert, die unterschiedlich zu der ersten Ausgabefrequenz (Fout1) ist,

   **dadurch gekennzeichnet,**

   - **daß** die PLL-Frequenzsyntheseschaltung (PFD, LF, VCO, DIV) nach Ablauf der ersten Periode (t0-t1) von der ersten Ausgabefrequenz (Fout1) auf eine geeignet im nutzbaren Frequenzband gelegene Einschwing-Basisfrequenz umprogrammiert wird, die unterschiedlich zu der zweiten Ausgabefrequenz (Fout2) ist und aus welcher heraus der Einschwingvorgang auf die zweite Ausgabefrequenz (Fout2) vorgenommen wird.

2. Verfahren nach Anspruch 1,
   **dadurch gekennzeichnet,**

   - **daß** es sich bei der Einschwing-Basisfrequenz um die Mittenfrequenz des für den FDMA-Betrieb vorgesehenen Frequenzbandes handelt.

3. Verfahren nach einem der vorhergehenden Ansprüche,
   **dadurch gekennzeichnet,**

   - **daß** der Datenübertragung eine TDMA-Struktur (Z1, Z2, Z3) zugrundeliegt, bei welcher der Beginn eines bestimmten Zeitschlitzes (Z1) mit dem Beginn (t0) der ersten Periode (t0-t1) zusammenfällt und der Beginn des nächsten Zeitschlitzes (Z2) mit dem Beginn der zweiten Periode (t2-t3) zusammenfällt, und wobei die Zeitdauer zwischen dem Ende der ersten Periode (t0-t1) und dem Anfang der zweiten Periode (t2-t3) kürzer ist als diejenige Einschwingzeit der PLL-Frequenzsyntheseschaltung (PFD, LF, VCO, DIV), die auftritt, wenn die PLL-Frequenzsyntheseschaltung (PFD, LF, VCO, DIV) vom deaktivierten Zustand auf die zweite Ausgabefrequenz (Fout2) geregelt würde.

4. Verfahren nach einem der vorhergehenden Ansprüche,
   **dadurch gekennzeichnet,**

   - **daß** die Datenübertragung gemäß Bluetooth-Standard erfolgt.

5. Verfahren nach einem der vorhergehenden Ansprüche,
   **dadurch gekennzeichnet,**

- **daß** die Datenübertragung gemäß DECT-Standard erfolgt.

## Claims

1. Method for operating a PLL frequency synthesis circuit for a TDMA/FDMA data transmission device, wherein in order to carry out a frequency change

   - the PLL frequency synthesis circuit (PFD, LF, VCO, DIV) is in an active state with data transmission activity (P1) and synthesizes a first output frequency (Fout1) during a first period (t0-t1),
   - no data transmission activity is carried out by the TDMA/FDMA data transmission device during an intermediate period (t1-t2) which follows the first, and
   - the PLL frequency synthesis circuit (PFD, LF, VCO, DIV) is in an active state once again with data transmission activity (P2) and synthesizes a second output frequency (Fout2), which is not the same as the first output frequency (Fout1), during a second period (t2-t3) which follows the intermediate period (t1-t2),

   **characterized**

   - **in that** the PLL frequency synthesis circuit (PFD, LF, VCO, DIV) is reprogrammed from the first output frequency (Fout1) to a stabilization basic frequency, which is located in a suitable manner in the usable frequency band, after the first period (t0-t1) has elapsed, which is different from the second output frequency (Fout2) and from which the stabilization process to the second output frequency (Fout2) is carried out.

2. Method according to Claim 1, **characterized**

   - **in that** the stabilization basic frequency is the mid-frequency of the frequency band that is provided for FDMA operation.

3. Method according to one of the preceding claims, **characterized**

   - **in that** the data transmission is based on a TDMA structure (Z1, Z2, Z3), in which the start of a specific time slot (Z1) coincides with the start (t0) of the first period (t0-t1), and the start of the next time slot (Z2) coincides with the start of the second period (t2-t3), and with the time period between the end of the first period (t0-t1) and the start of the second period (t2-t3) being shorter than that settle time of the PLL frequency synthesis circuit (PFD, LF, VCO, DIV) which would occur if the PLL frequency synthesis circuit (PFD, LF, VCO, DIV) were to be controlled from the deactivated state to the second output frequency (Fout2).

4. Method according to one of the preceding claims, **characterized**

   - **in that** the data is transmitted in accordance with the Bluetooth Standard.

5. Method according to one of the preceding claims, **characterized**

   - **in that** the data is transmitted in accordance with the DECT Standard.

## Revendications

1. Procédé pour faire fonctionner un circuit de synthèse de fréquence à boucle à phase asservie d'un dispositif de transmission de données à accès multiples par répartition dans le temps/accès multiples par répartition en fréquence, dans lequel pour effectuer un changement de fréquence

   - le circuit (PFD, LF, VCO, DIV) de synthèse de fréquence à boucle à phase asservie se trouve pendant une première période (t0-t1) ayant une activité (P1) de transmission de données dans un état actif et synthétise une première fréquence (Fout1) d'émission,
   - pendant une période (t1-t2) intermédiaire venant ensuite, il n'est pas prévu d'activité de transmission de données du dispositif de transmission de données à accès multiples par répartition dans le temps/accès multiples par répartition en fréquence, et
   - le circuit (PFD, LF, VCO, DIV) de synthèse de fréquence à boucle à phase asservie se retrouve, pendant une deuxième période (t2-t3) faisant suite à la période (t1-t2) intermédiaire et ayant une activité (P2) de transmission de données, dans un état actif et synthétise une deuxième fréquence (Fout2) d'émission qui est différente de la première fréquence (Fout1) d'émission,

   **caractérisé**

   - **en ce que** le circuit (PFD, LF, VCO, DIV) de synthèse de fréquence à boucle à phase asservie est, après expiration de la première période (t0-t1), reprogrammé de la première fréquence (Fout1) d'émission sur une fréquence de base transitoire mise de façon appropriée dans la bande de fréquence utile, qui est différente de la deuxième fréquence (Fout2) d'émission, et à partir de laquelle l'opération transitoire est effectuée sur la deuxième fréquence (Fout2) d'émission.

2. Procédé suivant la revendication 1,
    **caractérisé**

    - **en ce que** la fréquence de base transitoire est la fréquence médiane de la bande de fréquence prévue pour le fonctionnement en accès multiples par répartition en fréquence.

3. Procédé suivant l'une des revendications précédentes,
    **caractérisé**

    - **en ce qu'**une structure (Z1, Z2, Z3) à accès multiples par répartition dans le temps, est à la base de la transmission de données, structure dans laquelle le début d'un créneau (Z1) temporel déterminé coïncide avec le début (t0) de la première période (t0-t1) et le début du créneau (Z2) temporel immédiatement suivant coïncide avec le début de la deuxième période (t2-t3) et dans lequel le laps de temps entre la fin de la première période (t0-t1) et le début de la deuxième période (t2-t3) est plus court que le temps d'établissement du circuit (PFD, LF, VCO, DIV) de synthèse de fréquence à boucle à phase asservie qui se produirait si le circuit (PFD, LF, VCO, DIV) de synthèse de fréquence à boucle à phase asservie était réglé de l'état désactivé à la deuxième fréquence (Fout2) d'émission.

4. Procédé suivant l'une des revendications précédentes,
    **caractérisé**

    - **en ce que** la transmission de données s'effectue suivant la norme Bluetooth.

5. Procédé suivant l'une des revendications précédentes,
    **caractérisé**

    - **en ce que** la transmission de données s'effectue suivant la norme DECT.

EP 1 354 406 B1

Fig.1

Fig.2

Fig.3

8